# EUROPEAN PATENT APPLICATION

(11) **EP 4 498 434 A1**
(43) Date of publication of application: **29.01.2025**
(21) Application number: 23774797.7
(22) Date of filing: 17.03.2023
(51) Int. Cl.: H01L 27/146, G02B 3/00, G02B 5/18

(54) **SOLID-STATE IMAGING ELEMENT AND METHOD FOR MANUFACTURING SAME**

(30) Priority: 22.03.2022 JP 2022045402; 11.05.2022 JP 2022078200
(71) Applicant: Toppan Holdings Inc., Tokyo 110-0016 (JP)
(72) Inventor: TOMIOKA, Shungo, Tokyo 110-0016 (JP); HIDA, Hideo, Tokyo 110-0016 (JP); SHIMAZAKI, Tomohiro, Tokyo 110-0016 (JP)
(74) Representative: Hoffmann Eitle
(86) International application number: PCT/JP2023/010555
(87) International publication number: WO 2023/182202

(57) **Abstract**

Provided are a solid-state imaging element in which a diffraction grating pattern is formed with a high shape accuracy on a lens array, and a method for manufacturing the same. The solid-state imaging element (10) includes: a lens array (30) in which a plurality of micro lenses (31) are formed in an aligned arrangement; a flattening layer (40) formed on the lens array; and a diffraction grating part (50) which is composed of a thermosetting resin, has a plurality of diffraction gratings, and is provided on the flattening layer. Alternatively, the solid-state imaging element (10) includes: a lens array (30) in which a plurality of micro lenses (31) are in an aligned arrangement; a flattening layer (40) formed on the lens array; and a diffraction grating part (50) which has a base (51) that covers an entire upper surface of the flattening layer, and a plurality of diffraction gratings (52) provided so as to protrude from the base.

## Description

### [Technical Field]

The present invention relates to a solid-state imaging element. A method for manufacturing a solid-state imaging element will also be described.

### [Background Art]

Distance image sensors are known that use a solid-state imaging element, are portable and can also be incorporated into thin mobile phones.

For example, PTL 1 describes a photoelectric conversion substrate that includes a plurality of photoelectric conversion units and a micro lens array provided on the photoelectric conversion units. The micro lens array has the function of focusing incident light onto each of the photoelectric conversion units.

In recent years, as the applications of solid-state imaging elements have expanded and the structures have become more complex, cases have emerged in which other layers are formed on top of the micro lens array. For example, in the distance image sensor described above that uses a solid-state imaging element, a diffraction grating pattern is sometimes formed on the micro lens array. As a result of performing image processing of light that has been separated into the respective wavelengths by the diffraction gratings, it becomes possible to a measure distance using a distance image.

Because the upper surface of a micro lens array has unevenness, it is difficult to form a diffraction grating pattern directly on a micro lens array. Relatedly, PTL 2 discloses a flattening technique in which a micro lens array is covered with a protective film.

### [Citation List]

### [Patent Literature]

PTL 1: JP 2019-195051 A
PTL 2: JP 5668276 B

### [Summary of the Invention]

### [Technical Problem]

A diffraction grating pattern is generally formed by application of a photosensitive resin layer (resist), followed by light exposure and development, and then formation of a permanent film via a heating (baking) process at high temperature. The inventors have found that the shape accuracy of the diffraction gratings is insufficient in such pattern formation, which results in a deterioration of the optical properties, and have completed the present invention by solving this problem.

The present invention has an object of providing a solid-state imaging element in which a diffraction grating pattern is formed with a high shape accuracy on a lens array, and a method for manufacturing the same.

### [Solution to Problem]

A first aspect of the present invention is a solid-state imaging element including: a lens array in which a plurality of micro lenses are formed in an aligned arrangement; a flattening layer formed on the lens array; and a diffraction grating part which is composed of a thermosetting resin, has a plurality of diffraction gratings, and is provided on the flattening layer.

A second aspect of the present invention is a solid-state imaging element including: a lens array in which a plurality of micro lenses are formed in an aligned arrangement; a flattening layer formed on the lens array; and a diffraction grating part which is has a base that covers an entire upper surface of the flattening layer, and a plurality of diffraction gratings provided so as to protrude from the base.

A third aspect of the present invention is a solid-state imaging element including: a lens array in which a plurality of micro lenses are formed in an aligned arrangement; a flattening layer formed on the lens array; and a diffraction grating part which has a plurality of diffraction gratings, and is provided on the flattening layer; wherein the diffraction gratings have a lower surface on a flattening layer side, a substantially flat upper surface opposing the lower surface in a thickness direction, and a side surface that connects the lower surface and the upper surface, and the lower surface is longer than the upper surface.

A fourth aspect of the present invention is a method for manufacturing a solid-state imaging element.

The manufacturing method includes: a step A for providing a thermosetting resin layer on a flattening layer, the flattening layer being formed on a lens array in which a plurality of micro lens are formed in an aligned arrangement; a step B for forming a resist layer on the thermosetting resin layer, and forming a sacrificial pattern corresponding to diffraction gratings by light exposure and development; and a step C for performing dry etching without baking the sacrificial pattern, and transferring a shape of the sacrificial pattern to the thermosetting resin layer.

### [Advantageous Effects of the Invention]

According to the present invention, it is possible to provide a solid-state imaging element in which a diffraction grating pattern is formed with a high shape accuracy on a lens array, and a method for manufacturing the same.

### [Brief Description of the Drawings]

Fig. 1 is a schematic cross-sectional view of a solid-state imaging element according to the present embodiment.
Fig. 2 is a schematic cross-sectional view showing a manufacturing process of a solid-state imaging element according to a comparative example.
Fig. 3 is a schematic cross-sectional view showing a cross-sectional shape of a diffraction grating according to the present embodiment.
Fig. 4 is a schematic diagram of a pattern shape of diffraction gratings and diffracted light.
Fig. 5 is a schematic plan view showing a plan view shape of diffraction gratings according to the present embodiment.
Fig. 6 is a schematic cross-sectional view showing a manufacturing process of the solid-state imaging element according to the present embodiment.
Fig. 7 is a schematic cross-sectional view showing a manufacturing process of the solid-state imaging element according to the present embodiment.
Fig. 8 is a schematic cross-sectional view showing a manufacturing process of the solid-state imaging element according to the present embodiment.
Fig. 9 is a schematic view of a scanning electron micrograph of a diffraction grating part according to the present example.
Fig. 10 is a cross-sectional profile of diffraction gratings according to the present example.
Fig. 11 is a cross-sectional profile of diffraction gratings according to a comparative example.

### [Description of the Embodiment]

Hereinafter, an embodiment of the present invention (abbreviated as "the embodiment" below) will be described in detail. Note that the present invention is not limited to the embodiment below, and can be implemented with various modifications within the scope of the gist of the present invention. Also, the notation "~" includes the numerical values (boundary values) of both the lower limit value and the upper limit value. Furthermore, the terms "upper surface", "upper side", "lower surface", and "lower side" are used throughout the description, and are defined as follows. That is, the direction in which functional layers are laminated on the surface of a substrate 20 is the "upper side", and the direction toward the opposite side to the "upper side" is the "lower side". Furthermore, in each layer, the surface on the side facing the lamination direction is the "upper surface", and the surface on the opposite side is the "lower surface". Alternatively, the light-receiving surface is the "upper surface", and the surface on the opposite side is the "lower surface".

### <Outline of Solid-State Imaging Element According to Present Embodiment>

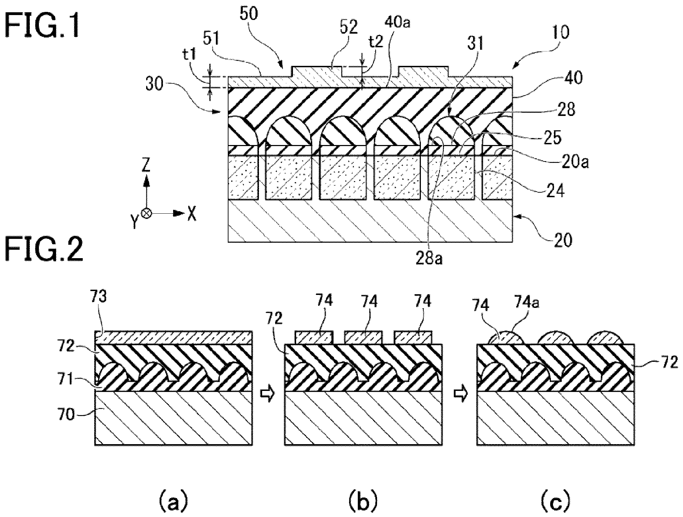

Fig. 1 is a schematic cross-sectional view of a solid-state imaging element according to the present embodiment. The solid-state imaging element 10 includes a substrate 20, CMOS image sensors 24, color filters 28, a lens array 30, a flattening layer 40, and a diffraction grating part 50, and as a whole, functions as a distance image sensor.

The substrate 20 is, for example, a silicon (Si) substrate. The material of the substrate 20 is a material such as silicon, but is not particularly limited as long as it is a material capable of supporting the pixels and light-receiving elements of the CMOS image sensors 24 and the like, and allows such components to electrically function. Hereinafter, the thickness direction of the substrate 20 is referred to as the Z direction, and the direction from the inside of the substrate 20 toward a surface 20a in the Z direction is referred to as the upper side. Furthermore, one direction that is parallel to the surface 20a and perpendicular to the Z direction is referred to as the X direction, and the direction that is parallel to the surface 20a and perpendicular to the X direction and the Z direction is referred to as the Y direction.

The solid-state imaging element 10 can include a plurality of CMOS image sensors 24. The plurality of CMOS image sensors 24 are aligned along each of the X direction and the Y direction. In this way, by providing a plurality of CMOS image sensors 24, a pixel array of solid-state imaging elements 10 is configured in directions across the surface 20a of the substrate 20. The number of CMOS image sensors 24 provided in the solid-state imaging element 10 is appropriately set according to the application and the like of the solid-state imaging element 10, and at least a portion of these are illustrated in Fig. 1 and the like.

The CMOS image sensors 24 are each embedded in the surface 20a side of the substrate 20 in the Z direction. A light-receiving surface 25 of the CMOS image sensors 24 is exposed from the substrate 20, and is substantially flush with the surface 20a. Note that, in Fig. 1 and the like, although illustration of the detailed structure of the CMOS image sensors 24 has been omitted, the structure is the same as that of a known CMOS image sensor.

The color filters 28 are provided on the light-receiving surface 25 of each of the CMOS image sensors 24 (that is, on the upper side in the Z direction). The color filters 28 each have the function of allowing light in a wavelength band of one of the three primary colors, namely red (R), green (G), and blue (B) to be transmitted. The color transmitted by the color filters 28 is appropriately determined for each of the plurality of CMOS image sensors 24 according to the arrangement and the like of the plurality of CMOS image sensors 24.

The lens array 30 is formed on the color filters 28, and includes a plurality of micro lenses 31 formed in an aligned arrangement corresponding to the color filters.

The micro lenses 31 are provided on the surface 28a of the color filters 28 on each of the CMOS image sensors 24. The micro lenses 31 are so-called plano-convex lenses having a bottom surface and a lens surface. The material of the micro lenses 31 has a refractive index that is at least higher than the refractive index of air and the flattening layer 40. In particular, in order to obtain a refractive index difference with the flattening layer 40 and enhance the light focusing effect of the micro lenses 31, it is preferable that the material of the micro lenses is a high refractive index material having, for example, a refractive index of about 1.6. The curvature and shape of the lens surface can be appropriately designed according to the refractive index and the like of the material of the micro lenses 31 at visible wavelengths. Furthermore, the micro lenses 31 are formed and arranged such that the light that enters from the upper side in the Z direction toward the opposite direction to the Z direction passes through the color filters 28 below (that is, on the lower side in the Z direction) is focused at the CMOS image sensors 24.

As a result of the flattening layer 40 being provided so as to cover the surface of the lens array 30, the unevenness of the micro lenses 31 is absorbed, and a substantially flat surface 40a is formed for providing the diffraction grating part 50. The surface 40a of the flattening layer 40 is flattened compared to the surfaces of the micro lenses 31. The maximum thickness of the flattening layer 40 (that is, the distance in the Z direction between the surface 40a of the flattening layer 40 and the surface 20a of the substrate 20 (the surface of the CMOS image sensors 24) is appropriately determined according to the optical path length and the like required for the light that enters the micro lenses 31 from the upper side in the Z direction.

The flattening layer 40 has at least a refractive index that is lower than the refractive index of the micro lenses 31. As the refractive index of the flattening layer 40 approaches the refractive index of air, it is possible to make the refractive index difference between the flattening layer 40 and the micro lenses 31 larger. As a result, it is possible to suppress refraction of light that enters the diffraction gratings of the diffraction grating part 50 from the upper side toward the lower side in the Z direction, and direct the course of the light that enters the diffraction gratings toward a predetermined direction. Consequently, light is well focused at the CMOS image sensors 24 by the micro lenses 31, and the desired optical characteristics can be obtained in the solid-state imaging element 10. The refractive index of the flattening layer 40 can be adjusted as appropriate.

In one example, the flattening layer 40 contains a hollow filler and a medium. The hollow filler and the medium have transparency at visible wavelengths, and have, for example, a total light transmittance of 90% or more with respect to light at visible wavelengths. The hollow filler contributes to lowering the refractive index of the flattening layer 40. The medium is interposed between the particles of the hollow filler, binds the hollow filler together, and stabilizes the flattening layer 40.

An example of a preferable material of the hollow filler is silicon dioxide (silica, SiO₂). A hollow filler made of silica is inexpensive, has high transparency at visible wavelengths, and physical stability. As a result of the hollow filler being located in a low refractive index layer, air regions are dispersed inside the flattening layer 40, which causes a reduction in the refractive index of the flattening layer 40, and results in the refractive index approaching the value of air as the content of the hollow filler increases.

The diffraction grating part 50 includes a layer-shaped base 51 that covers the surface 40a of the flattening layer 40, and a plurality of diffraction gratings 52 protruding from the base 51 toward the upper side in the Z direction. The base 51 and the diffraction gratings 52 are both formed of a thermosetting resin, and are integrated.

The diffraction gratings 52 have transparency at visible wavelengths, and have, for example, a total light transmittance of 90% or more with respect to light at visible wavelengths. The diffraction gratings 52 are periodically provided with a predetermined spacing in the X direction and the Y direction. The light that enters the diffraction gratings 52 from the upper side in the Z direction toward the lower side is diffracted by the diffraction gratings 52 at a diffraction angle that is determined by the wavelength of the light and the pitch of the diffraction gratings 52 with respect to the normal along the Z direction, and propagates in different directions for each wavelength.

The dimensions, the pitch, and the like, of the diffraction gratings 52 can be set as appropriate according to the purpose and the like.

### <Technical Background and Circumstances Leading to Solid-State Imaging Element 10 of Present Embodiment>

In recent years, distance image sensors have been used in facial recognition systems such as smartphones, and 3D sensing devices using CMOS image sensors that are inexpensive and can be made compact are being developed.

Here, diffraction gratings are used to convert a 2D image captured by conventional CMOS image sensors into a 3D image. As a result of performing image processing of light that has been separated into the respective wavelengths by the diffraction gratings, it becomes possible to measure a distance from a distance image.

In such a 3D device structure, the color filters 28 and the micro lenses 31 are formed on a semiconductor substrate provided with the CMOS image sensors, and then the flattening layer 40 is formed to flatten the unevenness of the surfaces of the micro lenses 31 and to lengthen the optical path, and the diffraction gratings are formed on the upper surface of the flattening layer 40.

FIGS. 2(a) to 2(c) are schematic cross-sectional views showing a manufacturing process of a solid-state imaging element according to a comparative example. Note that, in Fig. 2, the structure on the lower side of the flattening layer 72 is shown in a simplified manner. The reference sign 70 shown in Fig. 2 represents a semiconductor substrate provided with CMOS image sensors, the reference sign 71 represents a micro lens, and the reference sign 72 represents a flattening layer.

As shown in Fig. 2(a), a resist coating layer 73 is formed on the entire upper surface of the flattening layer 72 using a transparent photosensitive positive resist. Here, the resist that is used can be a resist used for micro lens applications.

As shown in Fig. 2(a), after forming the resist coating layer 73, in Fig. 2(b), light exposure and development are performed to form a pattern consisting of a plurality of diffraction gratings 74, and in Fig. 2(c), the diffraction gratings 74 are subjected to heat flow (baking). As a result of the above procedure, is possible to form a pattern consisting of the plurality of diffraction gratings 74 on the upper surface of the flattening layer 72.

However, as shown in Fig. 2(c), by performing heat flow (baking), the surface 74a of each diffraction grating 74 is deformed into a curved surface having an overall convex shape, and the rectangularity is reduced.

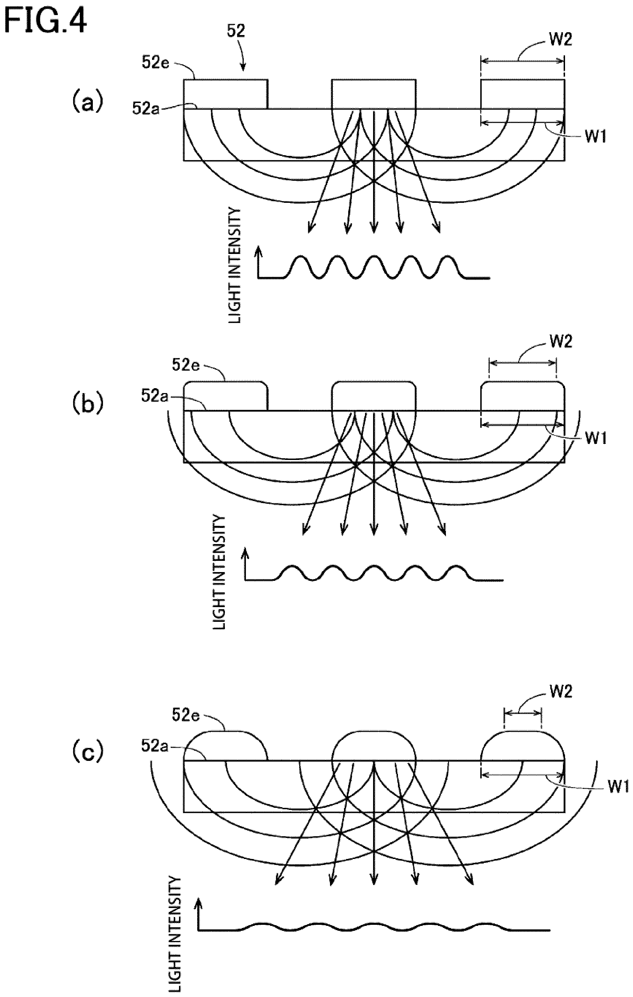

When the rectangularity is lost in this way, the influence of the lens effect becomes stronger, and the spacing between interference fringes of the diffracted light passing between the diffraction gratings 74 becomes wider than a normal spacing, causing a problem in that the desired optical characteristics (sensor characteristics) could not be obtained. Note that the problem of the interference fringes and the effects of the present embodiment will be described later using Fig. 4.

The "optical characteristics" (sensor characteristics) refer to the detection accuracy of measuring the distance to an object, and because the detection accuracy of the distance decreases when there is a reduction in the optical characteristics, it is necessary to increase the rectangularity of the diffraction gratings.

### <Detailed Description of Solid-State Imaging Element 10 According to Present Embodiment>

In the solid-state imaging element 10 according to the present embodiment, it is possible to increase the rectangularity of the diffraction gratings 52 compared to the conventional technique, and it is possible to obtain good sensor characteristics. Hereinafter, the shape of the diffraction grating part 50 will be mainly described in detail.

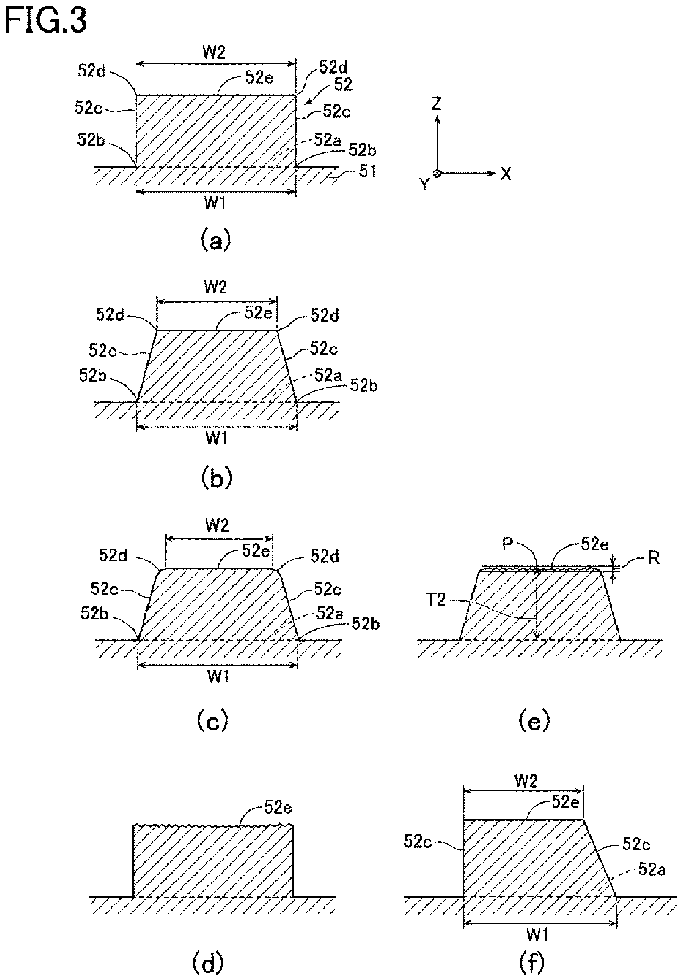

As shown in Fig. 1, the diffraction grating part 50 formed on the surface 40a of the flattening layer 40 is formed having a plurality of diffraction gratings 52. An enlarged cross-sectional view showing enlarged a portion containing only a diffraction grating 52 is shown in Fig. 3(a).

As shown in Fig. 3(a), the diffraction grating 52 includes a lower surface 52a on the flattening layer 40 side, a side surface 52c that stands up from a skirt portion 52b of the lower surface 52a toward the upper side in the Z direction, and a flat upper surface 52e that opposes the lower surface 52a in the thickness direction (Z direction) from the upper end portion of the side surface 52c via an inflection point 52d.

Note that the lower surface 52a of the diffraction grating 52 is integrated with the base 51, and therefore, is shown as a virtual line (dotted line). The lower surface 52a is the same surface as the surface of the base 51, and in Fig. 3(a), the lower surface 52 is shown as the same surface as the X-Y plane.

In Fig. 3(a), the side surface 52c extends parallel to the Z direction in the diagram, that is, in the vertical direction, and the upper surface 52e is formed by a surface parallel to the lower surface 52a. Fig. 3(a) shows an ideal shape of the diffraction grating 52, which is formed in a rectangular shape.

In the present embodiment, as described below, the diffraction grating 52 is formed by dry etching using a thermosetting resin. As a result, the rectangularity of the diffraction grating 52 can be increased. Therefore, as a first embodiment, the diffraction grating part 50 is formed of a thermosetting resin, and has a plurality of diffraction gratings 52.

Although the material of the thermosetting resin is not limited, the material can be selected from, for example, acrylic resins, epoxy resins, phenol resins, silicone resins, melamine resins, urea resins, and the like.

Furthermore, as a second embodiment, the diffraction grating part 50 includes the base 51 that covers the entire surface 40a of the flattening layer 40, and the plurality of diffraction gratings 52 provided so as to protrude from the base 51 (see Fig. 1).

In the present embodiment, a residual film layer can be formed between the diffraction gratings 52 by etching the diffraction grating layer formed on the entire surface 40a of the flattening layer 40 to a certain depth by dry etching. The residual film layer constitutes the layer-shaped base 51 by being integrated with the lower surface 52a side of the diffraction gratings 52. As a result of providing the base 51, it is possible to protect the flattening layer 40 and appropriately capture the diffracted light, which leads to an improvement in the sensor characteristics.

A thickness dimension t1 of the base 51 (see Fig. 1), although not limited, is preferably about 0.3 µm or more and 1.0 µm or less. As a result of ensuring the thickness dimension t1 of the base 51, the surface 40a of the flattening layer 40 can be appropriately protected. That is, as described above, the flattening layer 40 contains, for example, a filler. Consequently, the surface 40a of the flattening layer 40 is not truly flat, but is roughened. As a result, by having the thickness dimension t1 described above, the entire surface 40a of the flattening layer 40 can be covered with certainty. The "flattening" of the flattening layer 40 refers to absorbing the unevenness of the surfaces of the micro lenses 31 to form a flatter shape than the surfaces of the micro lenses 31, and is not limited to being a truly flat shape.

A preferable shape of the diffraction gratings 52 will be described using Fig. 3. As described above, the diffraction grating 52 shown in Fig. 3(a) has a rectangular shape in which a width dimension W1 of the lower surface 52a and a width dimension W2 of the upper surface 52e are the same length, but as shown in Fig. 3(b), the side surface 52c may be inclined such that the width dimension W2 of the upper surface 52e is smaller than the width dimension W1 of the lower surface 52a. In this case, the cross-sectional shape of the diffraction grating 52 is, for example a substantially trapezoidal shape (third embodiment).

The preferable dimension ranges of the diffraction grating 52 will be described. Note that, in each embodiment, the dimensions are not limited to the dimension ranges described below.

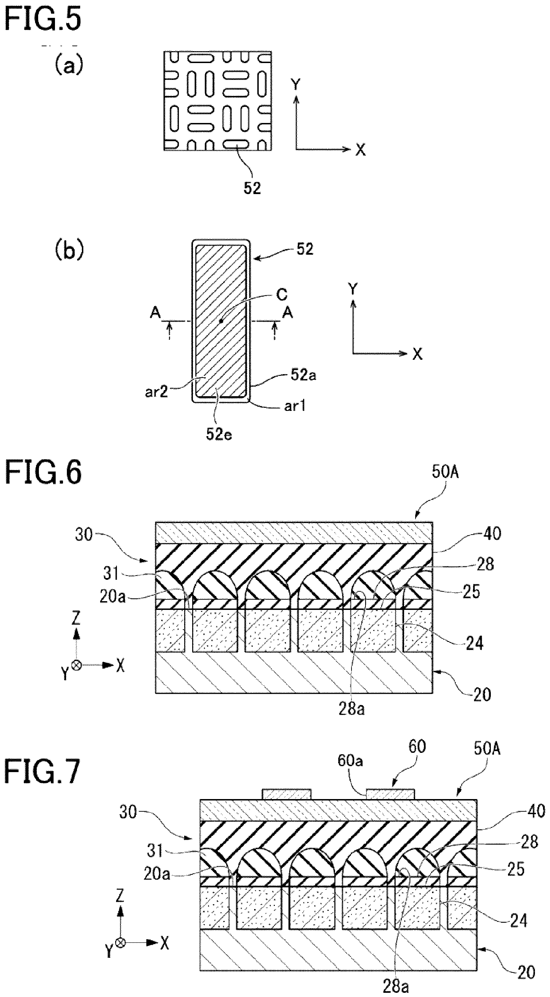

The width dimension W2 of the upper surface 52e is preferably 0.50 µm or more and 1.50 µm or less, more preferably 0.90 µm or more and 1.20 µm or less, and even more preferably 0.92 µm or more and 1.02 µm or less. Furthermore, the width dimension W1 of the lower surface 52a is preferably 1.00 µm or more and 1.70 µm or less, more preferably 1.10 µm or more and 1.50 µm or less, and even more preferably 1.12 µm or more and 1.24 µm or less. The distance between the upper surface 52e and the lower surface 52a (thickness dimension of the diffraction grating 52) is preferably 0.30 µm or more and 0.80 µm or less, is more preferably 0.50 µm or more and 0.70 µm or less, and even more preferably 0.58 µm or more and 0.66 µm or less. If the upper surface 52e, the lower surface 52a, and the thickness of the diffraction grating 52 are within the above ranges, the light that has entered the side surface 52c is also refracted and taken inside. As a result, the light can be diffracted in the same manner as the light that has entered the upper surface 52e, and the efficiency of light utilization can be improved. Therefore, various sensors with good performance can be configured by applying the solid-state imaging element of the present embodiment, and it is possible, for example, to improve the distance measurement accuracy and the like by application to a distance image sensor. Note that, when the diffraction gratings 52 are formed in the plan view pattern shown in Fig. 5 described below, although it is possible to propose a form in which the width dimension W1 of the lower surface 52a and the width dimension W2 of the upper surface 52e are included in the dimension ranges above for both the longitudinal direction and transverse direction cross-sections, or a form in which the width dimensions are included in the dimension ranges above for only one of the longitudinal direction and transverse direction cross-sections, it is preferable that the width dimension W1 of the lower surface 52a and the width dimension W2 of the upper surface 52e that appear in the transverse direction cross-section are included in the dimension ranges above.

In the present embodiment, it is preferable that the width dimension W2 of the upper surface 52e is 0.8 times or more and 1.0 times or less the width dimension W1 of the lower surface 52a. The dimensional ratio is represented by width dimension W2 / width dimension W1.

Fig. 4 is a schematic diagram of a pattern shape and diffracted light. In Fig. 4(a) represents a first experiment, in which the diffraction gratings 52 are substantially rectangular, and the width dimensions of the lower surface 52a and the upper surface 52e of the diffraction gratings 52 are the same dimensions (that is, the dimensional ratio is 1.0). Fig. 4(b) represents a second experiment, in which the upper surface 52e of the diffraction gratings 52 is 0.8 times the lower surface 52a. Fig. 4(c) represents a third experiment, in which the upper surface 52e of the diffraction gratings 52 is 0.6 times the lower surface 52a.

As shown in Figs. 4(a) to 4(c), as the dimensional ratio of the upper surface 52e of the diffraction gratings 52 to the lower surface 52a becomes smaller, the interference fringes become wider, the intensity distribution of the interference fringes becomes less sharp, and the variation also increases. In the first and second experiments in Figs. 4(a) and 4(b), it was found that, when applied to a distance image sensor, it is possible to suppress the variation in the distance measurement accuracy to a level that does not pose a problem in practice, and that good sensor characteristics can be obtained. Therefore, in the present embodiment, a width dimension W2 of the upper surface 52e which is 0.8 times or more and 1.0 times or less the width dimension W1 of the lower surface 52a is set as the preferable range.

In Figs. 3(a) and 3(b), the upper surface 52e of the diffraction grating 52 is a flat surface, and further, the inflection point 52d between the side surface 52c and the upper surface 52e is configured as a right angle or an obtuse angle, which can be considered an ideal shape, but in reality, as a result of going through the dry etching process of the present embodiment, the inflection point 52d tends to be formed with a rounded shape as shown in Fig. 3(c). In Fig. 3(c), the width dimension W1 of the upper surface 52e can be defined by excluding the inflection point 52d having the rounded shape.

Furthermore, as shown in Figs. 3(d) and 3(e), a configuration in which the upper surface 52e of the diffraction grating 52 is not truly flat, and is a roughened surface, is also included in the present embodiment. Note that, in Fig. 3(d), the side surface 52c extends in a substantially vertical direction, and in Fig. 3(e) the side surface 52c is inclined. The cross-sectional profile of the surface of the diffraction grating 52 can be measured using, for example, an atomic force microscope (AFM). At this time, the side surface 52c of the diffraction grating 52 is an etched surface formed by dry etching. Although the upper surface 52e is also affected by etching, because the upper surface 52e has a higher degree of roughness than the side surface 52c, the side surface 52c and the upper surface 52e can be defined with high accuracy based on the cross-sectional profile.

In the present embodiment, the upper surface 52e includes not only the truly flat form shown in Figs. 3(a) to 3(c), but also the roughened and substantially flat form shown in Figs. 3(d) and 3(e), where "substantially flat" can be defined as follows. That is, as shown in Fig. 3(e), the highest position (apex P) of the upper surface 52e is determined from the cross-sectional profile, and a thickness dimension T2 of the diffraction grating 52 at the apex P (the height from the lower surface 52a to the apex P) is measured. Then, a range R of 15% or less (preferably a range of 10% or less) of the thickness dimension T2 is defined on the lower side from the apex P, and if the upper surface 52e falls within the range R, the surface is defined as being "substantially flat". That is, even if the upper surface 52e has fine unevenness or is wavy, or the upper surface 52e is somewhat curved, the upper surface 52e corresponds to a "substantially flat" surface if it falls within the range R.

As shown in Fig. 3(f), a configuration is possible in which one side surface 52c extends in a perpendicular direction, and another side surface 52c is inclined. At this time, as described above, it is preferable that the width dimension W2 of the upper surface 52e is 0.50 µm or more and 1.50 µm or less, and the width dimension W1 of the lower surface 52a is 1.00 µm or more and 1.70 µm or less, or it is preferable that the width dimension W2 of the upper surface 52e is 0.8 times or more and 1.0 times or less the width dimension W1 of the lower surface 52a.

Fig. 5 is a schematic plan view showing a plan view shape of diffraction gratings according to the present embodiment. As shown in Fig. 5(a), the plurality of diffraction gratings 52 are formed having a long shape, and are regularly arranged with a spacing. However, the arrangement shown in Fig. 5(a) is an example, and the arrangement is not limited to this. That is, although the embodiment shown in Fig. 5(a) includes diffraction gratings 52 having a long shape in the Y direction and diffraction gratings 52 having a long shape in the X direction, a configuration is possible that includes only one of these, or diffraction gratings 52 may be arranged that are diagonally tilted with respect to the X direction and the Y direction. Furthermore, the aspect ratio in the X direction and the Y direction is not limited, and can be appropriately set according to the desired sensor characteristics, the application, and the like.

Fig. 5(b) is an enlarged plan view showing in an enlarged manner a diffraction grating 52 shown in Fig. 5(a). A cross-sectional view taken along line A-A and viewed from the direction of the arrow so as to pass through the center C of the diffraction grating 52 shown in Fig. 5(b) corresponds to the cross-section in Fig. 3. In Fig. 5(b), although the diffraction grating 52 is cut along the transverse direction (X direction), even when the cut is made along the longitudinal direction (Y direction) so as to pass through the center C, or the cut is made from a diagonal direction with respect to the X direction and the Y direction so as to pass through the center C, it is preferable that the width dimension W2 of the upper surface 52e that appears in the cross-section is 0.8 times or more and 1.0 times or less the width dimension W1 of the lower surface 52a.

Furthermore, because the value of (width dimension W2 / width dimension W1) can also be interpreted as an area ratio obtained by dividing the area of the upper surface 52e shown in Fig. 5(b) (ar2 shown by the diagonal lines) by the area of the lower surface 52a (ar1), in the present embodiment, the area ratio (ar2/ar1) is preferably in the range of 0.8 or more and 1.0 or less. Because the area ratio (ar2/ar1) only needs to be in the range of 0.8 or more and 1.0 or less, a case in which the value of (width dimension W2 / width dimension W1) is below 0.8 in certain cross-sections is included in the present embodiment.

Moreover, although not limited, the width dimensions (W1 and W2) of the cross-section that appears when the diffraction grating 52 shown in Fig. 5(b) is cut along the X direction, which is the transverse direction, is approximately 0.3 µm or more and 2.0 µm or less, and the width dimensions (W1 and W2) of the cross-section that appears when the cut is made along the Y direction, which is the longitudinal direction, is approximately 0.3 µm or more and the pixel area size or less.

### <Method for Manufacturing Solid-State Imaging Element 10 According to Present Embodiment>

The inventors have prepared and evaluated a large number of diffraction gratings formed by baking a photosensitive resist into a permanent film, and have found that many of the diffraction gratings did not perform as designed. A detailed observation of such diffraction gratings revealed a reason to be that the incident light did not behave in accordance with the settings due to insufficient flatness of the upper surface of the diffraction gratings. In addition, it was also discovered that the cause of insufficient flatness in many cases was that the resist that had reached a high temperature during baking was deformed in a convex shape (see Fig. 2).

Based on the above findings, the inventors solved the problem by forming diffraction gratings using a method that does not use the photosensitive resist itself as the diffraction gratings.

That is, in a photosensitive resist before baking, which has been subjected to light exposure and development, the shape corresponding to the photomask is reproduced with high precision, and the flatness of the upper surface of the pattern is also sufficiently maintained. Therefore, by not baking the resist and etching the resin layer that is provided below as a sacrificial pattern, production of a diffraction grating part having highly precise diffraction gratings with a sufficiently flat upper surface was successful.

An example of a method for manufacturing the solid-state imaging element 10 having the configuration described above will be described using the drawings.

First, the color filters 28 are provided on the substrate 20 formed having the CMOS image sensors 24, and then the plurality of micro lenses 31 aligned in a two-dimensional array are formed thereon. Examples of the method of forming the micro lenses 31 include a method in which a high refractive index material that forms the micro lenses 31 is applied in a layer form on at least the surfaces 28a of the color filters 28, providing a photoresist layer thereon, and etching and transferring a lens pattern formed by thermal melting after a photolithography process to the underlying layer of the high refractive index material.

Next, a coating liquid in which a low refractive index material containing a hollow filler and a medium is dispersed is coated so as to cover the surfaces of the color filters 28 and the micro lenses 31, and the surface 20a of the substrate 20 that are exposed therebetween, and the solvent is removed by applying heat and curing the coating. As a result, the flattening layer 40 is formed.

Next, as shown in Fig. 6, a thermosetting resin layer 50A is formed on the flattening layer 40 (step A). The thickness of the thermosetting resin layer 50A is at least the sum of the base 51 and the diffraction gratings 52 (the thickness dimension t1 + t2 shown in Fig. 1).

In addition, as shown in Fig. 7, a transparent photosensitive resist is used to form a sacrificial pattern 60 on the thermosetting resin layer 50A that corresponds to the diffraction gratings 52 (step B). The sacrificial pattern 60 is, for example, formed having the plan view pattern shown in Fig. 5(a).

The sacrificial pattern 60 is formed by applying a resist in a layer form, and through a light exposure and development process using a photomask, but because the sacrificial pattern 60 is not used as a permanent film, and in order to maintain a rectangular cross-section, curing by baking is not performed.

As shown in Fig. 7, the side surfaces 60a of the sacrificial pattern 60 are preferably formed along the Z direction, that is, in the vertical direction, but the shape is not limited to this. For example, when a form is used in which the side surfaces 60a are inclined such that the width dimension gradually decreases from the lower surface toward the upper side, it becomes easier for the side surfaces 52c of the diffraction gratings 52 to also be inclined along the side surfaces 60a, and the diffraction gratings can be precisely formed in a substantially trapezoidal shape. The incline of the side surfaces 52c of the diffraction gratings 52 can be adjusted by adjusting the inclination angle and the like of the side surfaces 60a of the sacrificial pattern 60.

The thickness dimension of the sacrificial pattern 60 is not limited, but is preferably about several tens of nm or more and several hundreds of nm or less. The thickness dimension is adjusted in consideration of the effect of dry etching of the sacrificial pattern 60.

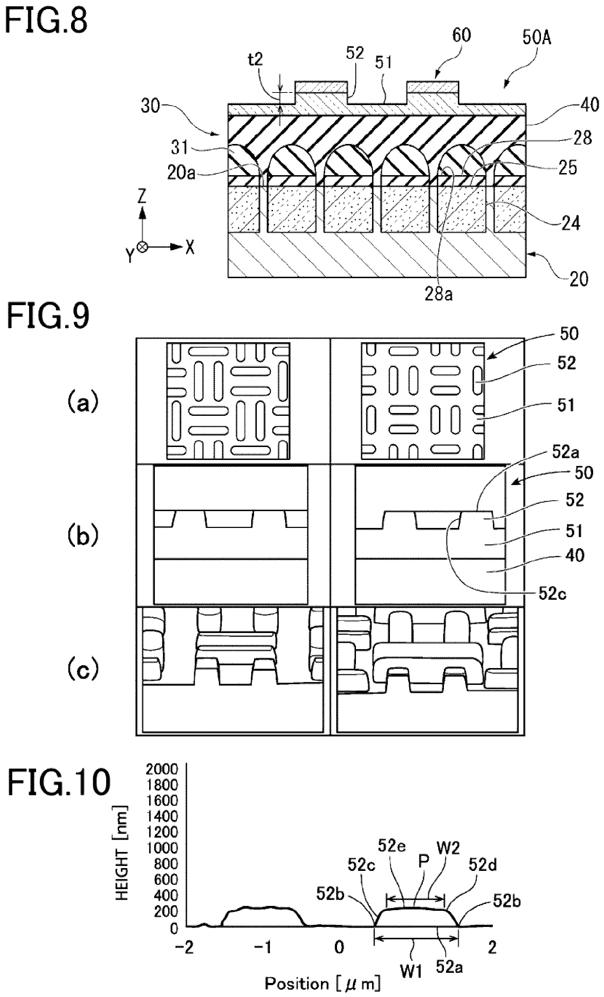

Then, dry etching is performed using the sacrificial pattern 60 (step C). As a result, the shape of the sacrificial pattern 60 is transferred to the thermosetting resin layer 50A, and the diffraction gratings 52 are formed. The dry etching is completed such that the thermosetting resin layer 50A is not completely removed and still remains in those parts where the sacrificial pattern 60 is not formed. At this time, the depth dimension t2 is adjusted using dry etching conditions. The depth dimension t2 is the thickness dimension of the diffraction gratings 52. As a result, as shown in Fig. 8, the thermosetting resin layer 50A becomes the diffraction grating part 50, in which the plurality of diffraction gratings 52 protrude from the base 51 that covers the flattening layer 40 without any gaps. Then, the sacrificial pattern 60 shown in Fig. 8 is removed.

The solid-state imaging element 10 including the diffraction grating part 50 is manufactured as a result of the steps described above.

Because the diffraction gratings according to the present embodiment are capable of diffracting incident light as designed, various sensors with good performance can be configured by application to a solid-state imaging element. For example, by applying the solid-state imaging element according to the present embodiment to a distance image sensor, the distance measurement accuracy and the like can be improved.

When configured to have a low refractive index, the flattening layer 40 has a porous configuration with a large number of voids as described above, but in the configuration according to the present embodiment, because the flattening layer 40 is completely covered by the base 51, the flattening layer 40 is suitably protected, and there is also an advantage in that it is possible to prevent detachment of filler, infiltration of liquids, and the like.

Although an embodiment of the present invention has been described in detail above, the present invention is not limited to specific embodiments, and includes modifications, combinations, and the like, of configurations within a scope not departing from the spirit of the present invention. A number of modifications are illustrated below, but these are not exhaustive, and other modifications are also possible. Two or more of the modifications may also be combined as appropriate.

· In the diffraction grating part according to the present invention, the thicknesses of the base and the diffraction gratings are not particularly limited, and the magnitude relationship between the two is also not limited. Therefore, the diffraction gratings may be thicker or thinner than the base, or may be the same thickness as the base.

· In the diffraction grating part according to the first embodiment and the third embodiment, the base is not essential. Therefore, it is possible to adjust the dry etching process and to remove the base, and obtain a configuration including only the diffraction gratings.

· In the third embodiment, the "substantially trapezoidal shape" only requires that the shape has an upper base (upper surface) and a lower base (lower surface), and that the upper base and the lower base are approximately parallel, and is not a concept that includes only a geometric trapezoid. For example, a configuration such as that as shown in Fig. 3(f), in which one side surface 52c extends in the vertical direction and the other side surface 52c is inclined, is also included.

· In the embodiments described above, an on-chip type solid-state imaging element has been illustrated in which color filters are directly formed on a substrate, but the application scope of the technical ideas according to the present invention is not limited to this, and can be applied, for example, to the diffraction gratings and the like that are arranged on an organic EL (OLED).

### [Examples]

Hereinafter, the present invention will be described in detail using examples carried out in order to clarify the effects of the present invention. Note that the present invention is not limited in any way by the following examples.

FIG. 9 shows a schematic diagram of a scanning electron microscope (SEM) image of the diffraction grating part 50 according to the present embodiment manufactured by the method described above. Fig. 9(a) is a schematic diagram of an SEM photograph viewed in a plan view, Fig. 9(b) is a schematic diagram of a cross-sectional SEM photograph, and Fig. 9(c) is a schematic diagram of a SEM photograph as viewed from the upper diagonal side. As shown in Figs. 9(a) and 9(c), it was found that the plurality of diffraction gratings 52 were regularly arranged.

As shown in Fig. 9(b), it was found that the diffraction gratings 52 had a substantially rectangular shape, and that the plurality of diffraction gratings 52 had a shape protruding from the layer-shaped base. It was found that the upper surfaces of the diffraction gratings 52 are substantially flat and approximately parallel to the upper surfaces of the base 51 and the flattening layer 40. Furthermore, the side surface 52c in the cross section was a steeply inclined surface, and the cross-sectional shape was a substantially trapezoidal shape as a whole.

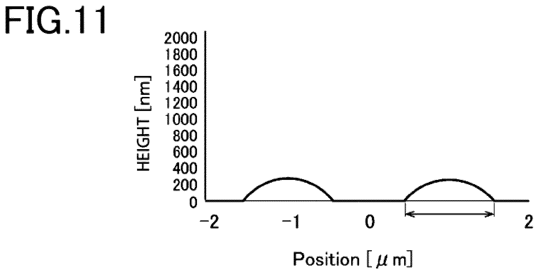

Fig. 10 is a cross-sectional profile of diffraction gratings manufactured by the manufacturing method according to the present example, and Fig. 11 is a cross-sectional profile of diffraction gratings manufactured by the manufacturing method according to the comparative example shown in Fig. 2.

The cross-sectional profiles shown in Figs. 10 and 11 were measured using an atomic force microscope. In the example shown in FIG. 10, it was found that the upper surface was a roughened surface. First, from Fig. 10, because the skirt portions 52b can be clearly recognized, the distance between the skirt portions 52b was measured and used as the width dimension W1 of the lower surface 52a.

Next, the side surfaces 52c standing up from the skirt portions 52b could be recognized. It was found that the side surfaces 52c had a lower degree of roughness than the upper surface 52e.

As shown in Fig. 10, the upper surface 52e that extends substantially parallel to the lower surface 52a from the upper end portion of the side surface 52c via the inflection point 52d were observed. Because the inflection point 52d had a rounded shape, the upper surface 52e was defined by excluding the arc abutting the roundness.

As shown in Fig. 10, the upper surface 52e was a roughened surface. This is considered to be due to some roughness that occurred when the sacrificial pattern 60 was removed during the manufacturing process.

The apex P of the upper surface 52e shown in FIG. 10 was measured, and the thickness dimension that was measured from the apex P to the lower surface 52a was approximately 250 nm. Furthermore, the thickness dimension of the upper surface 52e at the lowest position was about 220 nm. In this way, there was a difference of about 30 nm between the apex P and the lowest position of the upper surface 52e. The difference was about 12% with respect to the thickness dimension at the apex P. This extent of change in the shape of the upper surface was considered to be "substantially flat". Therefore, in the present example, a change of up to 15% was defined as "substantially flat".

Then, the width dimensions of the lower surface 52a and the upper surface 52e shown in Fig. 10 were measured. The width dimension W1 of the lower surface 52a was approximately 1.1 µm, and the width dimension W2 of the upper surface 52e was approximately 0.9 µm. Therefore, the ratio of the width dimension W2 of the upper surface 52e to the width dimension W1 of the lower surface 52a was about 0.82.

In this way, in the example shown in Fig. 10, the dimensional ratio W2/W1 was within the range of 0.8 or more and 1.0 or less, and as shown in Fig. 4(a), the shape enabled the spread of the interference fringes to be suppressed, and the desired sensor characteristics to be obtained.

On the other hand, Fig. 11 is a cross-sectional profile of the diffraction grating obtained in the manufacturing process of the comparative example shown in Fig. 2, and as shown in Fig. 11, the entire surface of the diffraction grating was elliptical. Note that the thickness dimension from the apex of the diffraction grating to the lower surface was about 250 nm.

For the shape of the comparative example shown in Fig. 11, the interference fringes are more spread out and blurred than in the shape pattern shown in Fig. 4(c), and because the sensor characteristics are significantly reduced, it was found that the diffraction gratings could not be precisely manufactured by the manufacturing process of Fig. 2.

Note that a measurement error in determining the dimensional ratio is allowed within a certain range (for example, about ± several %).

The present application is based on Japanese Patent Application No. 2022-045402 filed on March 22, 2022 and Japanese Patent Application No. 2022-078200 filed on May 11, 2022. These contents are included herein in their entirety.

## Claims

1. A solid-state imaging element comprising:
a lens array in which a plurality of micro lenses are formed in an aligned arrangement;
a flattening layer formed on the lens array; and
a diffraction grating part which is composed of a thermosetting resin, has a plurality of diffraction gratings, and is provided on the flattening layer.

2. The solid-state imaging element according to claim 1, wherein
the diffraction grating part has a base that covers an entire upper surface of the flattening layer, and
the diffraction gratings are provided so as to protrude from the base.

3. A solid-state imaging element comprising:
a lens array in which a plurality of micro lenses are formed in an aligned arrangement;
a flattening layer formed on the lens array; and
a diffraction grating part which has a base that covers an entire upper surface of the flattening layer, and a plurality of diffraction gratings provided so as to protrude from the base.

4. The solid-state imaging element according to claim 1, wherein a refractive index of the flattening layer is lower than a refractive index of the micro lenses.

5. A solid-state imaging element comprising:
a lens array in which a plurality of micro lenses are formed in an aligned arrangement;
a flattening layer formed on the lens array; and
a diffraction grating part which has a plurality of diffraction gratings, and is provided on the flattening layer; wherein
the diffraction gratings have a lower surface on a flattening layer side, a substantially flat upper surface opposing the lower surface in a thickness direction, and a side surface that connects the lower surface and the upper surface, and
the lower surface is longer than the upper surface.

6. The solid-state imaging element according to claim 5, wherein
a width dimension of the upper surface is 0.8 times or more and 1.0 times or less a width dimension of the lower surface.

7. The solid-state imaging element according to claim 5, wherein the upper surface is a rougher surface than the side surface.

8. The solid-state imaging element according to claim 5, wherein
a width dimension of the upper surface is 0.92 µm or more and 1.02 µm or less, and
a width dimension of the lower surface is 1.12 µm or more and 1.24 µm or less.

9. A method for manufacturing a solid-state imaging element, the method comprising:
step A for providing a thermosetting resin layer on a flattening layer, the flattening layer being formed on a lens array in which a plurality of micro lens are formed in an aligned arrangement;
step B for forming a resist layer on the thermosetting resin layer, and forming a sacrificial pattern corresponding to diffraction gratings by light exposure and development; and
step C for performing dry etching without baking the sacrificial pattern, and transferring a shape of the sacrificial pattern to the thermosetting resin layer.

10. The method for manufacturing a solid-state imaging element according to claim 9, wherein
in step C, a shape of the sacrificial pattern is transferred to the thermosetting resin layer to form a plurality of diffraction gratings, while also leaving a portion of the thermosetting resin layer between the diffraction gratings.
